# EUROPÄISCHE PATENTSCHRIFT

(11) **EP 2 650 256 B1**
(45) Veröffentlichungstag und Bekanntmachung des Hinweises auf die Patenterteilung: **09.12.2015**
(21) Anmeldenummer: 13162904.0
(22) Anmeldetag: 09.04.2013
(51) Int. Cl.: B81C 1/00, B81C 99/00

(54) **Verfahren zur Herstellung eines mikrostrukturierten Formkörpers**
Method for manufacturing a microstructured device
Procédé de fabrication d'un dispositif microstructuré

(30) Priorität: 12.04.2012 DE 102012103174
(43) Veröffentlichungstag der Anmeldung: 16.10.2013
(73) Patentinhaber: Technische Universität Ilmenau, 98693 Ilmenau (DE)
(72) Erfinder: Schober, Andreas, 99096 Erfurt (DE); Hampl, Jörg, 99087 Erfurt (DE); Weise, Frank, 98693 Ilmenau (DE); Schlingloff, Gregor, 98693 Ilmenau (DE); Fernekorn, Uta, 99094 Erfurt (DE)
(74) Vertreter: Engel, Christoph Klaus

(56) Entgegenhaltungen:
- DE-A1-102009 044 112
- DE-A1-102009 044 115
- US-A1- 2012 043 693

## Beschreibung

Die vorliegende Erfindung betrifft ein Verfahren zur Herstellung eines mikrostrukturierten Formkörpers, welcher insbesondere zur Kultivierung von biologischen Zellen vorgesehen ist.

Die DE 10 2004 035 267 B3 zeigt einen mikrostrukturierten Formkörper und ein Verfahren zu dessen Herstellung. Der Formkörper besteht aus einer Folie, in die mindestens eine Hohlstruktur eingebracht ist. Der gesamte Formkörper, d. h. sowohl die Folie als auch die Hohlstrukturen weisen eine Vielzahl von Poren auf, deren Durchmesser bevorzugt einen Wert zwischen 10 nm und 10 µm annimmt. Die Poren sind statistisch über den ganzen Formkörper verteilt. Ein Nachteil dieser Lösung besteht darin, dass Flüssigkeiten über die gesamte Oberfläche hinweg durch den Formkörper hindurchdringen können, wohingegen es bei der Kultivierung von biologischen Zellen innerhalb des Formkörpers vorteilhaft ist, Flüssigkeiten gezielt auf die Zellen lenken zu können.

Die DE 10 2009 044 115 A1 zeigt einen mikrostrukturierten Formkörper mit perforierten Teilen und ein Verfahren zu dessen Herstellung. Bei diesem Verfahren wird eine verformbare erste Folie mit einer Dicke von weniger als 1 mm über einer zweiten Folie angeordnet. In der zweiten Folie befinden sich durchgängige Ausnehmungen mit einem Durchmesser von weniger als 2 mm. Die erste Folie wird in die Ausnehmungen in der zweiten Folie eingeformt, sodass Kavitäten in der ersten Folie entstehen. Die erste Folie weist Poren auf, wobei die Poren nur innerhalb der Kavitäten durchlässig sind.

Ein weiteres mikrostrukturiertes Verbundbauteil sowie Verfahren und Vorrichtung zu dessen Herstellung ist aus DE 10 2009 044 112 A1 bekannt.

Aus der DE 10 2007 050 976 A1 ist ein Verfahren zur Umformung einer Folie bekannt, bei welchem die umzuformende Folie fest mit einer Formkulisse, die mindestens einen Durchbruch aufweist, verbunden wird. Anschließend werden Bereiche der umzuformenden Folie einer physikalischen oder chemischen Modifikation unterworfen. Die derart modifizierte und mit der Formkulisse verbundene Folie wird in ein Formwerkzeug eingelegt und dort mit einem Druckmedium beaufschlagt, welches die Folie zumindest teilweise in den Durchbruch der Formkulisse einformt.

Die US 6,599,612 B1 lehrt ein Verfahren zur Herstellung einer weichen, elastischen Bahn oder Folie mit einem durchgehenden Muster von Vertiefungen oder Durchbrüchen. Solche Bahnen sind vorgesehen als Kontaktflächen oder Deckfolien für saugfähige Hygieneartikel, wie Windeln, Servietten, Wundauflagen oder dergleichen. In zwei Phasen werden über Lochwalzen zunächst eine Mikroperforation und dann eine etwa viermal größere Makroperforation in die Folie eingebracht, sodass eine weiche, aber stabile Folie entstehen soll. Die hergestellten Mikroperforationen sind etwa 0,05 mm bis 0,5 mm groß, während die Makroperforationen typischerweise etwa 0,3 mm bis 3 mm groß sind.

Die DE 10 2009 044 113 A1 zeigt einen teilweise perforierten mikrostrukturierten Formkörper und ein Verfahren zu dessen Herstellung. Bei diesem Verfahren wird eine verformbare Folie partiell verstreckt, sodass Verstreckungsbereiche mit einer verringerten Dicke entstehen. Anschließend werden Mikrostrukturen in zumindest einigen der verdünnten Verstreckungsbereiche ausgeformt. Weiterhin werden Poren in zumindest einem der verdünnten Verstreckungsbereiche erzeugt, während zumindest einige der unverformten Bereiche undurchlässig bleiben.

Aus der EP 0 305 123 A1 ist ein Verfahren zur Herstellung einer im Wesentlichen flüssigkeitsundurchlässigen Warenbahn mit Mikrobläschen bekannt. Bei diesem Verfahren wird eine aus einer Polymerfolie bestehende Bahn über eine Trommel transportiert. Auf der Trommel befindet sich eine Struktur, in welche die Polymerfolie mithilfe eines mit hohem Druck beaufschlagten Wasserstrahles eingeformt wird, wodurch Mikrobläschen geschaffen werden. Dabei verbleiben nahezu unverdünnte Bereiche und es entstehen verdünnte Bereiche, welche tief in die Struktur eingeformt werden. Diese Mikrobläschen stellen allein aufgrund ihres Durchmessers keine Poren dar.

Die DE 101 34 040 A1 zeigt ein Verfahren zur Herstellung von mikrofluidischen Hohlstrukturen aus Kunststoff. In einem einzigen Prozesszyklus wird eine thermoplastische Kunststofffolie durch ein gasförmiges oder flüssiges Druckmedium zu fluidischen Mikrostrukturen thermogeformt. Gleichzeitig wird die Kunststofffolie mit einem starren oder starrflexiblen, nicht zu thermoformenden Substrat durch Einwirkung von Temperatur und Druck verbunden.

Die DE 10 2007 023 286 A1 zeigt ein Verfahren zur Herstellung einer Membran in einem Rahmen. Bei diesem Verfahren wird eine umzuformende Folie bereitgestellt, die durch Pressen der Folie mit einem flüssigen Kunststoff unter Druck in eine Positiv- oder in eine Negativform umgeformt wird. Nach dem Verformen bildet sich ein fester Kunststoff aus, woraufhin das Entformen des Verbundes aus ungeformter Folie und erstarrter Schmelze erfolgt.

Die DE 37 23 404 A1 betrifft eine flüssigkeitsdurchlässige Folie, welche beispielsweise als Deckfolie saugfähiger Hygieneartikel verwendet wird. Die Folie weist Öffnungen auf, die in auf der Folienunterseite vorragenden Ausprägungen liegen. Die engste Stelle der Ausprägungen ist gegenüber der Folienoberseitenebene versenkt.

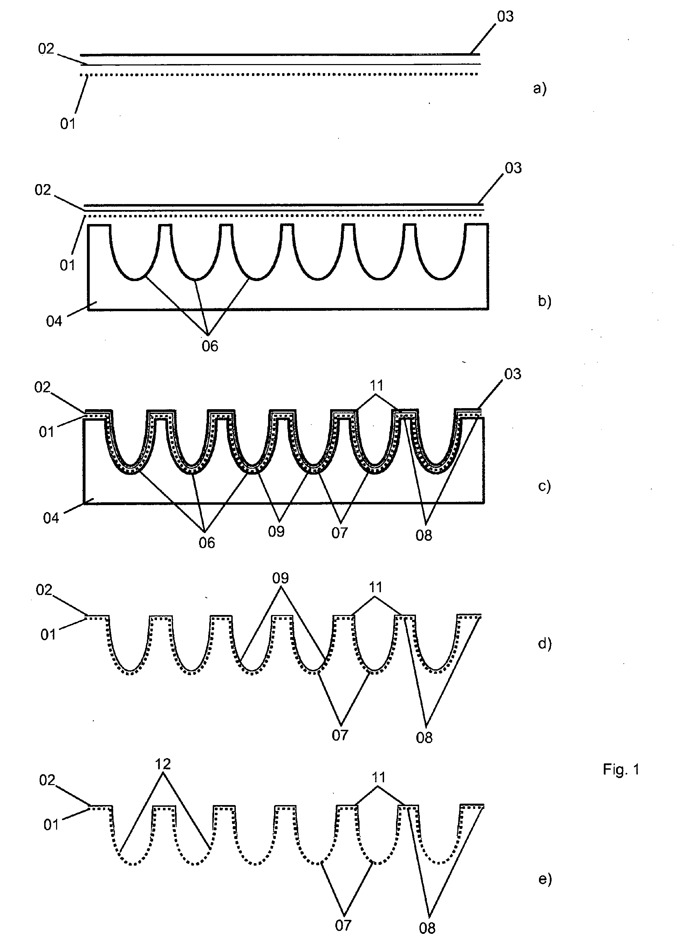

In dem wissenschaftlichen Artikel von Hebeiss I. et al.: "Novel three-dimensional Boyden chamber system for studying transendothelial transport" in Lab on a Chip, 2012, 12, Seiten 829 - 834 ist u. a. die Kultivierung von Zellen in Mikrokanalstrukturen gezeigt. Fig. 1 dieses Artikels zeigt die Herstellung dieser Mikrokanalstrukturen, wofür eine poröse Folie aus Polycarbonat in eine Form eingeformt wird. Anschließend wird eine nichtporöse Folie aus Polycarbonat auf die ausgeformte Folie aufgebracht, wobei die nichtporöse Folie bereits Ausnehmungen aufweist, damit die ausgeformten Bereiche offen bleiben. Ein Nachteil dieser Lösung besteht darin, dass die Ausnehmungen in der nichtporösen Folie mit einem hohen Aufwand gegenüber den ausgeformten Bereichen in der porösen Folie positioniert werden müssen, damit diese deckungsgleich übereinander liegen. Dieses Verfahren ist nicht für die Massenherstellung solcher Strukturen geeignet.

Die Aufgabe der vorliegenden Erfindung besteht ausgehend vom Stand der Technik darin, ein Verfahren zur Herstellung eines mikrostrukturierten Formkörpers mit begrenzt porösen Bereichen innerhalb der Mikrostrukturen bereitzustellen, welches aufwandsarm durchführbar ist und für eine Massenherstellung derartiger Formkörper geeignet ist.

Die genannte Aufgabe wird durch ein Verfahren gemäß dem beigefügten Anspruch 1 gelöst.

Das erfindungsgemäße Verfahren dient der Herstellung eines mikrostrukturierten Formkörpers, welcher insbesondere zur Kultivierung von biologischen Zellen geeignet ist. Das Verfahren umfasst zunächst einen Schritt, in welchem eine plastisch verformbare, poröse erste Folie bereitgestellt wird, die eine Vielzahl an Poren aufweist. Die Poren sind bevorzugt als Mikroporen ausgebildet und sind statistisch über die Folie hinweg verteilt. Die Poren sind durchgängig von der einen Seite zu der anderen Seite der Folie ausgebildet, sodass sie durchlässig sind. Bevorzugt sind die Poren auf der ersten Folie statistisch gleich verteilt. Weiterhin wird eine verformbare zweite Folie bereitgestellt. In einem weiteren Schritt des erfindungsgemäßen Verfahrens wird eine verformbare erste Opferfolie bereitgestellt. Die erste Folie, die zweite Folie und die erste Opferfolie werden zu einem Folienstapel gestapelt. Dabei liegen innerhalb des Folienstapels die erste Folie und die zweite Folie gemeinsam der ersten Opferfolie gegenüber, sodass die erste Opferfolie nicht zwischen der ersten Folie und der zweiten Folie liegt. Somit liegt die erste Folie zwischen der zweiten Folie und der ersten Opferfolie oder die zweite Folie liegt zwischen der ersten Folie und der ersten Opferfolie. Grundsätzlich kann die erste Folie oder die zweite Folie unmittelbar an der ersten Opferfolie liegen. Im nächsten Schritt des erfindungsgemäßen Verfahrens wird die erste Opferfolie mit einem Druck, beispielsweise einem Pressdruck beaufschlagt, um den Folienstapel in eine Form zu pressen. Die Form weist Ausnehmungen auf, wodurch in der ersten Opferfolie, in der ersten Folie und in der zweiten Folie jeweils verformte Bereiche in Form von Kavitäten ausgebildet werden und unverformte Bereiche verbleiben. Die Ausnehmungen in der Form bestimmen die Form der in den Folien ausgebildeten Kavitäten. Die unverformten Bereiche können durch Flächen gebildet sein, die sich zwischen den verformten Bereichen befinden. Grundsätzlich können die unverformten Bereiche sehr klein sein, beispielsweise auch als Kante oder Spitze zwischen den verformten Bereichen.

Beim Pressen des Folienstapels in die Form werden die erste Folie und die zweite Folie miteinander verbunden, sodass sie einen Folienverbund ausbilden. Die verformte erste Folie und die verformte zweite Folie bilden somit gemeinsam ein einziges Werkstück aus. Ein Trennen der ersten Folie von der zweiten Folie würde zur Zerstörung des Werkstückes führen. Bei bevorzugten Ausführungsformen des erfindungsgemäßen Verfahrens wird die Form nach dem Verformen der Folien von den Folien entfernt. In einem nächsten Schritt des erfindungsgemäßen Verfahrens wird die verformte erste Opferfolie vom Folienverbund entfernt. Zu diesem Zeitpunkt bilden die verformte erste Folie und die verformte zweite Folie den doppelschichtigen Folienverbund, sodass die Poren in der verformten ersten Folie durch die verformte zweite Folie einseitig verschlossen sind.

In einem weiteren Schritt des erfindungsgemäßen Verfahrens erfolgt ein Ätzen von zumindest Teilen der verformten Bereiche der zweiten Folie, wodurch zumindest Abschnitte in den verformten Bereichen der zweiten Folie chemisch aufgelöst und somit vernichtet werden. In diesen Abschnitten der verformten zweiten Folie werden Abschnitte in den verformten Bereichen der ersten Folie freigelegt, sodass die Poren in diesen Abschnitten der ersten Folie wieder geöffnet werden. Im Ergebnis bildet der geätzte Folienverbund einen Formkörper, der in seinen unverformten Bereichen flüssigkeitsundurchlässig ist, da die dort befindlichen Poren der ersten Folie durch die verbleibenden Abschnitte der zweiten Folie verschlossen sind. Der Formköper weist Kavitäten auf, in denen zumindest Abschnitte vorhanden sind, in welchen die Poren in der verformten ersten Folie geöffnet sind, sodass ein Flüssigkeitsaustausch mit dem inneren Volumen der Kavitäten erfolgen kann.

Ein großer Vorteil des erfindungsgemäßen Verfahrens besteht darin, dass es keiner genauen Ausrichtung zwischen der ersten Folie und der zweiten Folie bedarf. Ein weiterer Vorteil besteht darin, dass das Verfahren für einen Rolle-zu-Rolle-Betrieb geeignet ist.

Beim Pressen der ersten Folie und der zweiten Folie in die Form werden die erste Folie und die zweite Folie besonders bevorzugt stoffschlüssig miteinander verbunden, sodass der Folienverbund und der im Ergebnis des Verfahrens vorliegende Formkörper hohen Belastungen ausgesetzt werden kann, ohne in seine Einzelbestandteile zerlegt und somit zerstört zu werden.

Die unverformten Bereiche der ersten Folie und die unverformten Bereiche der zweiten Folie liegen im ausgebildeten Folienverbund bevorzugt übereinander. In gleicher Weise liegen die verformten Bereiche der ersten Folie und die verformten Bereiche der zweiten Folie im ausgebildeten Folienverbund bevorzugt übereinander. Besonders bevorzugt liegen die unverformten Bereiche der ersten Folie und die unverformten Bereiche der zweiten Folie im ausgebildeten Folienverbund passgenau übereinander. In gleicher Weise liegen die verformten Bereiche der ersten Folie und die verformten Bereiche der zweiten Folie im ausgebildeten Folienverbund besonders bevorzugt passgenau übereinander.

Bei bevorzugten Ausführungsformen des erfindungsgemäßen Verfahrens wird beim Stapeln der ersten Folie, der zweiten Folie und der ersten Opferfolie die zweite Folie zwischen der ersten Folie und der Opferfolie angeordnet. Folglich befindet sich die zweite Folie nach dem Formen auf der Innenseite der Kavitäten. Bei alternativen bevorzugten Ausführungsformen wird beim Stapeln der ersten Folie, der zweiten Folie und der ersten Opferfolie die erste Folie zwischen der zweiten Folie und der Opferfolie angeordnet. Bei diesen Ausführungsformen befindet sich die zweite Folie nach dem Formen auf der äußeren Seite der Kavitäten.

Die Poren in der ersten Folie weisen beim Bereitstellen einen Durchmesser von bevorzugt zwischen 10 nm und 10 µm auf. Bei besonders bevorzugten Ausführungsformen weisen die Poren in der ersten Folie beim Bereitstellen einen Durchmesser zwischen 100 nm und 5 µm, weiter bevorzugt zwischen 500 nm und 2 µm auf.

Die Dichte der Poren in der ersten Folie, d. h. die Anzahl der Poren je Fläche der Folie, beträgt beim Bereitstellen bevorzugt mindestens 10⁵ Poren je cm², besonders bevorzugt mindestens 10⁶ Poren je cm². Die Dichte der Poren in der ersten Folie beträgt beim Bereitstellen bevorzugt höchstens 10⁷ Poren je cm².

Die erste Folie weist beim Bereitstellen eine Dicke von bevorzugt zwischen 1 µm und 1 mm, weiter bevorzugt zwischen 10 µm und 200 µm auf. Bei besonders bevorzugten Ausführungsformen des erfindungsgemäßen Verfahrens beträgt die Dicke der ersten Folie beim Bereitstellen zwischen 20 µm und 80 µm.

Die erste Folie weist beim Bereitstellen eine Breite und eine Länge auf, die bevorzugt jeweils zwischen 1 cm und 50 cm, besonders bevorzugt zwischen 5 cm und 20 cm betragen.

Die erste Folie besteht bevorzugt aus einem biokompatiblen Material, besonders bevorzugt aus einem biokompatiblen Kunststoff. Bei besonders bevorzugten Ausführungsformen des erfindungsgemäßen Verfahrens wird Polycarbonat (PC) als Material für die erste Folie verwendet. Bei alternativen bevorzugten Ausführungsformen wird Cyclo-Olefin-Copolymer (COC), Styrol-Acylnitril (SAN) oder Polystyrol (PS) als Material für die erste Folie verwendet.

Die zweite Folie weist beim Bereitstellen bevorzugt eine geschlossene Oberfläche in ihrer Haupterstreckungsebene auf, sodass die Poren in der ersten Folie sicher verschlossen werden können. Daher weist die zweite Folie beim Bereitstellen bevorzugt keine Öffnungen, insbesondere keine Poren auf, welche sich von einer Seite der zweiten Folie zu der anderen Seite der zweiten Folie erstrecken.

Die zweite Folie ist beim Bereitstellen in ihrer Haupterstreckungsebene bevorzugt flüssigkeitsdicht, insbesondere wasserdicht ausgebildet, sodass keine Flüssigkeiten durch die Poren in der ersten Folie hindurch weiter durch die zweite Folie hindurchdringen können.

Bei besonderen Ausführungsformen ist die zweite Folie vorstrukturiert, insbesondere durch Mikrostrukturen.

Bei weiteren besonderen Ausführungsformen weist die zweite Folie innenliegende Hohlkanäle auf, die sich im Wesentlichen parallel zur Haupterstreckungsebene der zweiten Folie erstrecken. Die Hohlkanäle treten an den Kanten der zweiten Folie aus. Als Kanten sind hier die schmalen Seitenflächen der zweiten Folie bezeichnet, deren Höhe durch die Dicke der zweiten Folie bestimmt ist und die senkrecht zur Haupterstreckungsebene der zweiten Folie angeordnet sind. Somit erlauben die Hohlkanäle einen Stofftransport innerhalb des auszubildenden Formkörpers, wobei dieser Stofftransport im Wesentlichen senkrecht zu einem Stofftransport durch die Poren ausgerichtet ist. Insbesondere erlauben die Hohlkanäle und die Poren den Transport von unterschiedlichen Stoffen.

Die zweite Folie weist beim Bereitstellen eine Dicke von bevorzugt zwischen 0,1 µm und 100 µm, besonders bevorzugt zwischen 1 µm und 10 µm auf. Bei besonders bevorzugten Ausführungsformen des erfindungsgemäßen Verfahrens beträgt die Dicke der zweiten Folie beim Bereitstellen zwischen 3 µm und 7 µm.

Die zweite Folie besteht bevorzugt aus einem Kunststoff.

Die erste Opferfolie weist bevorzugt eine geschlossene Oberfläche auf, sodass sie keine Öffnungen oder Poren besitzt. Die erste Opferfolie ist bevorzugt gasdicht, insbesondere luftdicht ausgebildet, sodass sie mit einem Luftdruck als Pressdruck zum Verformen beaufschlagt werden kann, ohne dass dieser Druck als Gasdruck auf die erste und/oder zweite Folie wirkt und diese beschädigt.

Die erste Opferfolie weist beim Bereitstellen eine Dicke von bevorzugt zwischen 1 µm und 500 µm, besonders bevorzugt zwischen 10 µm und 100 µm auf. Bei besonders bevorzugten Ausführungsformen des erfindungsgemäßen Verfahrens weist die erste Opferfolie beim Bereitstellen eine Dicke zwischen 20 µm und 80 µm auf.

Die erste Opferfolie besteht bevorzugt aus einem Kunststoff, beispielsweise einem Fluorkarbon oder Silikon. Besonders bevorzugt besteht die erste Opferfolie aus Perfluorethylenpropylen (FEP).

Die erste Folie, die zweite Folie und die erste Opferfolie sind vor dem Verformen bevorzugt eben. Die ebene Ausführung der Folien erlaubt ein problemloses Stapeln der Folien.

Die erste Folie, die zweite Folie und die erste Opferfolie werden bei dem Stapeln bevorzugt deckungsgleich übereinander angeordnet. Hierfür weisen die erste Folie, die zweite Folie und die erste Opferfolie vor dem Verformen bevorzugt eine gleiche Länge auf. Gleichzeitig weisen die erste Folie, die zweite Folie und die erste Opferfolie vor dem Verformen bevorzugt eine gleiche Breite auf.

Die Form weist bevorzugt eine Vielzahl an Ausformungen zur Formung von Kavitäten auf. Die Ausformungen sind bevorzugt zylindrisch mit jeweils einem kuppelförmigen Böden ausgebildet. Alternativ können die Ausformungen prismatisch oder sphärensegmentartig ausgebildet sein.

Die Ausformungen in der Form weisen einen Durchmesser von bevorzugt zwischen 50 µm und 500 µm auf. Da die Ausformungen die Ausmaße der in der ersten Folie und in der zweiten Folie zu formenden Kavitäten bestimmen, weisen die Kavitäten dementsprechend einen äußeren Durchmesser von bevorzugt zwischen 50 µm und 500 µm auf.

Die Ausformungen in der Form weisen eine Tiefe von bevorzugt zwischen 50 µm und 1.000 µm auf. Da die Ausmaße der Ausformungen die Ausmaße der in der ersten Folie und in der zweiten Folie zu formenden Kavitäten bestimmen, weisen die Kavitäten dementsprechend eine Tiefe von bevorzugt zwischen 50 µm und 1.000 µm auf.

Die Ausformungen in der Form sind bevorzugt regelmäßig angeordnet, sodass auch die Kavitäten innerhalb der Haupterstreckungsrichtung des zu schaffenden Formkörpers regelmäßig angeordnet sind. Bei bevorzugten Ausführungsformen des erfindungsgemäßen Verfahrens sind die Ausformungen in der Form in einem orthogonalen oder einem hexagonalen Raster angeordnet. Alternativ können die Ausformungen stochastisch in der Haupterstreckungsebene der Form verteilt sein.

Die Form besteht bevorzugt aus einem Metall, besonders bevorzugt aus Messing.

Beim Beaufschlagen der ersten Opferfolie mit einem Druck wird bevorzugt ein erhöhter Luft- oder Gasdruck als Pressdruck verwendet. Mithilfe des erhöhten Luftdruckes wird der Folienstapel in die Ausformungen in der Form hineingeformt.

Die unverformten Bereiche der ersten Folie und die unverformten Bereiche der zweiten Folie bleiben bevorzugt eben ausgebildet, sodass sie eine Haupterstreckungsebene des Folienverbundes und des zu schaffenden Formkörpers bilden. Die unverformten Bereiche liegen bevorzugt innerhalb einer einzigen Ebene.

Zumindest die Mehrzahl der Kavitäten ist bevorzugt gleich ausgebildet. Auch erstrecken sich die Kavitäten ausgehend von den unverformten Bereichen bezogen auf ihre Tiefe bevorzugt in dieselbe Richtung.

Der Folienverbund ist in seiner Haupterstreckungsebene bevorzugt zwischen 1 cm mal 1 cm und 50 cm mal 50 cm, besonders bevorzugt zwischen 5 cm mal 5 cm und 20 cm mal 20 cm groß.

Die bevorzugt stoffschlüssige Verbindung zwischen der ersten Folie und der zweiten Folie wird bevorzugt unmittelbar durch den ausgeübten Druck, insbesondere durch den Pressdruck geschaffen. Dabei kommt es bevorzugt zu einem Laminierungsvorgang.

Die erste Folie und die zweite Folie werden bevorzugt unmittelbar oder mittelbar während des Pressens erwärmt, um die Ausbildung der stoffschlüssigen Verbindung zu fördern. Bevorzugt werden die erste Folie und die zweite Folie mindestens bis zu einer Glasübergangstemperatur des für die erste Folie verwendeten Materials erwärmt.

Bei besonderen Ausführungsformen des erfindungsgemäßen Verfahrens wird beim Stapeln der ersten Folie, der zweiten Folie und der ersten Opferfolie weiterhin Klebstoff zwischen der ersten Folie und der zweiten Folie angeordnet, welcher nach dem Pressen erstarrt und zur stoffschlüssigen Verbindung zwischen der ersten Folie und der zweiten Folie führt. Die erste Folie und/oder die zweite Folie weisen hierfür bevorzugt eine Klebeschicht auf, welche nach dem Pressen erstarrt und zur stoffschlüssigen Verbindung zwischen der ersten Folie und der zweiten Folie führt. Die eine bzw. die beiden Klebeschichten befinden sich nach dem Stapeln der ersten Folie, der zweiten Folie und der ersten Opferfolie zwischen der ersten Folie und der zweiten Folie.

Die stoffschlüssige Verbindung ist bevorzugt durch eine Schweißverbindung zwischen der ersten Folie und der zweiten Folie gebildet. Die Verbindung zwischen der ersten Folie und der zweiten Folie kann auch durch eine Kombination verschiedener Verbindungsarten gebildet sein. Beispielsweise kann die Verbindung auch teilweise durch eine kraftschlüssige Verbindung gebildet sein.

Das Ätzen von zumindest Teilen der verformten Bereiche der zweiten Folie erfolgt bevorzugt dadurch, dass der Folienverbund in ein Ätzbad aus einer Ätzflüssigkeit getaucht wird. Im einfachsten Fall wird der Folienverbund vollständig in das Ätzbad getaucht. Da das erfindungsgemäße Verfahren insbesondere auch für einen Rolle-zu-Rolle-Betrieb geeignet ist, erfolgt das Tauchen des Folienverbundes in das Ätzbad bevorzugt dadurch, dass der Folienverbund durch das Ätzbad hindurchgezogen wird. Das Ätzbad wird während des Ätzens bevorzugt einem Ultraschall ausgesetzt, um eine Bläschenbildung an dem Folienverbund zu vermeiden.

Bei besonderen Ausführungsformen des erfindungsgemäßen Verfahrens wird der Folienverbund nur soweit in das Ätzbad getaucht, dass sich nur die verformten Bereiche der zweiten Folie im Ätzbad befinden.

Bei bevorzugten Ausführungsformen des erfindungsgemäßen Verfahrens wird der Folienverbund mit seiner Haupterstreckungsebene senkrecht zum Flüssigkeitsspiegel des Ätzbades in das Ätzbad getaucht.

Die ebenen unverformten Bereiche der ersten Folie liegen bevorzugt gemeinsam in der Haupterstreckungsebene des Folienverbundes.

Zum Ätzen wird bevorzugt Natronlauge verwendet, sodass die Ätzflüssigkeit durch Natronlauge gebildet ist. Die Natronlauge weist eine Konzentration des Natriumhydroxides von bevorzugt zwischen 30 % und 50 % auf.

Die Ätzflüssigkeit, insbesondere die Natronlauge weist während des Ätzens eine Temperatur von bevorzugt zwischen 50°C und 90°C, besonders bevorzugt zwischen 65°C und 75°C auf.

Die Dauer des Ätzens beträgt bevorzugt zwischen 10 min und 100 min, besonders bevorzugt zwischen 30 min und 60 min.

Die erste Folie und die zweite Folie werden beim Pressen in die Ausnehmungen der Form verstreckt, sodass die erste Folie in ihren verformten Bereichen und die zweite Folie in ihren verformten Bereichen verdünnt sind. Dabei nimmt die Verdünnung mit der Tiefe der Kavität zu, sodass die Verdünnung am Boden der Kavität maximal ist. Für das erfindungsgemäße Verfahren ist insbesondere relevant, dass die zweite Folie in den verformten Bereichen verdünnt ist. Es bedarf daher keines örtlich selektiven Ätzens der zweiten Folie, um ausschließlich Abschnitte in den verformten Bereichen der zweiten Folie vollständig aufzulösen, damit dort die Abschnitte der ersten Folie freigelegt werden. Das chemische Auflösen ist somit auf die Abschnitte in den verformten Bereichen der zweiten Folie begrenzt, ohne dass es einer besonderen Maßnahme bedarf. Im einfachsten Fall kann der Folienverbund vollständig in die Ätzflüssigkeit getaucht werden. Die unverformten Bereiche der zweiten Folie sind unverdünnt, sodass sie durch das Ätzen lediglich verdünnt, aber nicht vollständig aufgelöst werden. Diejenigen Abschnitte der verformten Bereiche der zweiten Folie, welche an die unverformten Bereiche der zweiten Folie angrenzen, sind infolge der Verformung lediglich etwas verdünnt, sodass auch diese Abschnitte der zweiten Folie durch das Ätzen bevorzugt nicht vollständig aufgelöst, sondern nur etwas weiter verdünnt werden.

Die Dicke der zweiten Folie in den verformten Bereichen ist bereits nach dem Verformen und vor dem Ätzen reduziert. Die Dicke der zweiten Folie in den verformten Bereichen beträgt unmittelbar nach dem Verformen, aber vor dem Ätzen bevorzugt weniger als 80 % der Dicke der zweiten Folie vor dem Verformen. Besonders bevorzugt beträgt die Dicke der zweiten Folie in den verformten Bereichen unmittelbar nach dem Verformen, aber vor dem Ätzen weniger als 50 % der Dicke der zweiten Folie vor dem Verformen. Weiterhin bevorzugt beträgt die Dicke der zweiten Folie in den verformten Bereichen unmittelbar nach dem Verformen, aber vor dem Ätzen weniger als 30 % der Dicke der zweiten Folie vor dem Verformen.

Durch das Verformen der ersten Folie in den verformten Breichen kommt es neben einer Verdünnung der ersten Folie auch dazu, dass die Poren in der ersten Folie größere Ausmaße annehmen. Bevorzugt weisen die Poren in den verformten Bereichen der ersten Folie infolge des Verformens einen durchschnittlichen Durchmesser auf, welcher mehr als 150 %, besonders bevorzugt mehr als 200 % des durchschnittlichen Durchmessers der Poren vor dem Verformen beträgt.

Für das erfindungsgemäße Verfahren ist es von Bedeutung, dass das Ätzen dermaßen an den verformten Folienverbund angepasst ist, dass die aufzulösenden Abschnitte der zweiten Folie chemisch vollständig aufgelöst und somit vernichtet werden, und dass die freigelegten Abschnitte der ersten Folie mit den dort vorhandenen Poren als solche erhalten bleiben, auch wenn es zu einer Verdünnung dieser Abschnitte und zu einer Vergrößerung der Poren kommt. Daher werden bei bevorzugten Ausführungsformen des erfindungsgemäßen Verfahrens der Stoff zum Ätzen, die Temperatur des Stoffes zum Ätzen, die Dauer des Ätzens, die Dicke und das Material der ersten Folie, die Dicke und das Material der zweiten Folie, die nach dem Verformen resultierende Dicke der verformten Bereiche der ersten Folie und die nach dem Verformen resultierende Dicke der verformten Bereiche der zweiten Folie so bemessen, dass die Abschnitte in den verformten Bereichen der zweiten Folie chemisch vollständig aufgelöst und vernichtet werden und dass die freigelegten Abschnitte der ersten Folie als poröse Folie erhalten bleiben.

Es kann zumeist nicht vollständig verhindert werden, dass auch die erste Folie in den freigelegten Abschnitten infolge des Ätzens verdünnt wird. Da sich die freigelegten Abschnitte der ersten Folie in deren verformten Bereichen befinden, sind diese Abschnitte ohnehin bereits durch das Verformen gegenüber der ursprünglichen Dicke der ersten Folie verdünnt. Bevorzugt weisen die freigelegten Abschnitte der ersten Folie nach dem Ätzen eine Dicke auf, die mindestens 30 %, besonders bevorzugt mindestens 50 % der Dicke dieser Abschnitte der ersten Folie unmittelbar vor dem Ätzen, aber nach dem Verformen beträgt.

Es ist zumeist nicht völlig vermeidbar, dass die Poren in den freigelegten Abschnitten der ersten Folie infolge des Ätzens in ihren Ausmaßen vergrößert werden. Diese Poren sind zumeist bereits unmittelbar vor dem Ätzen dadurch vergrößert, dass die erste Folie in den verformten Bereichen verstreckt ist, sodass die erste Folie dort verdünnt ist, was gleichzeitig zu einer Vergrößerung der Poren führt. Bevorzugt weisen die Poren in den freigelegten Abschnitten der ersten Folie nach dem Ätzen einen durchschnittlichen Durchmesser auf, der weniger als 200 % des durchschnittlichen Durchmessers der Poren beträgt, welcher unmittelbar vor dem Ätzen, aber nach dem Verformen gegeben war.

Zur Durchführung des erfindungsgemäßen Verfahrens ist es von Vorteil, eine bestimmte Ätzselektivität zwischen der zweiten Folie und der ersten Folie einzustellen. Unter dieser Ätzselektivität wird hier das Verhältnis des beim Ätzen aufgelösten Volumens der zweiten Folie zu dem beim Ätzen aufgelösten Volumen der ersten Folie verstanden, wenn jeweils eine gleiche Dauer des Ätzens, ein gleicher Stoff zum Ätzen und auch im Übrigen gleiche Bedingungen während des Ätzens gewählt werden. Die Ätzselektivität der zweiten Folie bezogen auf die erste Folie beträgt bevorzugt mindestens 1,3; besonders bevorzugt mindestens 1,5. Die Ätzselektivität kann insbesondere durch die Wahl der Materialien für die erste Folie und für die zweite Folie beeinflusst werden. Bevorzugt werden als Materialien für die zweite Folie Stoffe verwendet, bei denen es sich um durch Additive modifiziertes Polycarbonat oder Polyarylat handelt. Derartige Stoffe sind beispielsweise unter den Bezeichnungen Arryphan und Pokalon bekannt. Diese Stoffe weisen gegenüber Polycarbonat eine Ätzselektivität von 1,3 bzw. 1,7 auf.

Die beim Ätzen aufgelösten Abschnitte der zweiten Folie umfassen bevorzugt nur einen Teil der verformten Bereiche der zweiten Folie. Bevorzugt verbleiben nach dem Ätzen die unverformten Bereiche der zweiten Folie und Teile der an die unverformten Bereiche angrenzenden verformten Bereiche in der oberen Hälfte der Kavitäten. Hingegen sind die freigelegten Abschnitte in den verformten Bereichen der ersten Folie bevorzugt in der tieferen Hälfte der Kavitäten angeordnet. Ein vollständiges Auflösen der verformten Bereiche der zweiten Folie ist zum einen technologisch nur aufwändig durchführbar und zum anderen für die meisten Anwendungen nicht gewünscht, um sicherzustellen, dass es in den unverformten Bereichen oder deren Nähe nicht zu einem Flüssigkeitsaustausch durch freigelegte Poren kommt.

Die verbleibenden Teile der an die unverformten Bereiche der zweiten Folie angrenzenden verformten Bereiche der zweiten Folie weisen eine Höhe auf, die bevorzugt zwischen 10 % und 90 %, besonders bevorzugt zwischen 40 % und 60 % der Tiefe der Kavitäten beträgt.

Die freigelegten Abschnitte der ersten Folie in den verformten Bereichen der ersten Folie weisen eine Höhe auf, die bevorzugt zwischen 10 % und 90 %, besonders bevorzugt zwischen 40 % und 60 % der Tiefe der Kavitäten beträgt.

Bei besonderen Ausführungsformen des erfindungsgemäßen Verfahrens werden die Poren in der ersten Folie während des Verformens beidseitig geschlossen, wofür eine dritte Folie verwendet wird. Dementsprechend wird eine dritte Folie bereitgestellt, wobei die dritte Folie gemeinsam mit der ersten Folie, der zweiten Folie und der ersten Opferfolie zu dem Folienstapel gestapelt wird. Dabei wird die erste Folie zwischen der zweiten Folie und der dritten Folie angeordnet. Die erste Folie, die zweite Folie und die dritte Folie liegen gemeinsam der ersten Opferfolie gegenüber. Beim Pressen des Folienstapels über die erste Opferfolie in die Form werden auch in der dritten Folie verformte Bereiche in Form von Kavitäten ausgebildet, wobei unverformte Bereiche verbleiben. Dabei werden nicht nur die erste Folie und die zweite Folie miteinander verbunden, sondern auch die erste Folie und die dritte Folie werden bevorzugt stoffschlüssig miteinander verbunden. Die erste Folie, die zweite Folie und die dritte Folie bilden somit gemeinsam den Folienverbund aus. Beim Ätzen werden zumindest auch Teile der verformten Bereiche der dritten Folie geätzt, wodurch zumindest Abschnitte in den verformten Bereichen der dritten Folie chemisch aufgelöst und vernichtet werden. Dadurch werden in den verformten Bereichen der ersten Folie Abschnitte freigelegt, die zumindest teilweise deckungsgleich zu denjenigen Abschnitten der ersten Folie sind, die durch die aufgelösten Abschnitte der zweiten Folie freigelegt werden. Diejenigen Poren in der ersten Folie, die sowohl durch die aufgelösten Abschnitte der zweiten Folie, als auch durch die aufgelösten Abschnitte der dritten Folie freigelegt werden, werden somit durchlässig und können in dem gebildeten Formkörper zum Flüssigkeitstransport dienen.

Die dritte Folie weist bevorzugt auch diejenigen Merkmale und Eigenschaften auf, die für die zweite Folie als bevorzugt angegeben sind. Auch die für die zweite Folie angegebenen Wechselwirkungen mit der ersten Folie gelten in gleicher Weise für die dritte Folie.

Weitere besondere Ausführungsformen des erfindungsgemäßen Verfahrens führen zu mehrschichtigen Kavitäten, d. h. zu Kavitäten, welche Zwischenböden in Form von weiteren Folien aufweisen. Hierfür umfasst das Verfahren folgende weitere Schritte. Zunächst ist eine plastisch verformbare vierte Folie bereitzustellen, die vergleichbar mit der ersten Folie porös ist und eine Vielzahl an Poren aufweist. Dabei handelt es sich insbesondere um Mikroporen, welche bevorzugt statistisch verteilt, besonders bevorzugt statistisch gleich verteilt sind. Weiterhin ist eine zweite Opferfolie bereitzustellen. Die nachfolgend angeführten Schritte sind nach dem Entfernen der ersten Opferfolie, bevorzugt aber vor dem Ätzen durchzuführen. Die vierte Folie und die zweite Opferfolie sind auf den bereits ausgebildeten, die verformte erste Folie und die verformte zweite Folie umfassenden Folienverbund zu stapeln. Dabei befindet sich die vierte Folie zwischen dem zu diesem Zeitpunkt ausgebildeten Folienverbund und der zweiten Opferfolie. Die vierte Folie schließt dabei mit den Hohlräumen der Kavitäten im Folienverbund ab. Im nächsten Schritt ist die zweite Opferfolie mit einem Druck, insbesondere mit einem Pressdruck zu beaufschlagen, um die vierte Folie in den in der Form befindlichen Folienverbund zu pressen, wodurch in der zweiten Opferfolie und in der vierten Folie jeweils verformte Bereiche in Form von Kavitäten innerhalb der Kavitäten des Folienverbundes ausgebildet werden und unverformte Bereiche verbleiben. Die vierte Folie wird zumindest in deren unverformten Bereichen bevorzugt stoffschlüssig mit dem Folienverbund verbunden, sodass auch die vierte Folie Bestandteil des Folienverbundes wird. Im Anschluss ist die zweite Opferfolie zu entfernen.

Ein besonderer Vorteil der eingebrachten vierten Folie besteht darin, dass sie als eine Art Zwischenboden in der Kavität fungieren kann. Hierfür weisen die Kavitäten in der verformten vierten Folie bevorzugt eine geringere Höhe bzw. Tiefe als die Kavitäten in der verformten ersten Folie auf. Die durchschnittliche Tiefe der Kavitäten in der verformten vierten Folie beträgt bevorzugt zwischen 20 % und 80 % der durchschnittlichen Tiefe der Kavitäten in der verformten ersten Folie.

Damit die verformte vierte Folie als Zwischenboden fungieren kann, weisen die Poren in der vierten Folie bevorzugt einen größeren Durchmesser als die Poren in der ersten Folie auf. Daher weisen die Poren in der vierten Folie einen durchschnittlichen Durchmesser auf, der bevorzugt mehr als doppelt so groß wie der durchschnittliche Durchmesser der Poren in der ersten Folie ist.

Da die Funktion der vierten Folie in vielerlei Hinsicht der Funktion der ersten Folie gleicht, weist die vierte Folie bevorzugt auch diejenigen Merkmale und Eigenschaften auf, welche für die erste Folie als bevorzugt angegeben sind. In gleicher Weise weist auch die zweite Opferfolie bevorzugt auch diejenigen Merkmale auf, welche für die erste Opferfolie als bevorzugt angegeben sind.

Neben der vierten Folie können auch weitere Folien als weitere Zwischenböden in den zu schaffenden Formkörper eingebracht werden. Eine weitere besondere Ausführungsform des erfindungsgemäßen Verfahrens sieht daher die Verwendung einer fünften Folie vor. Gemäß dieser Ausführungsform sind folgende Schritte durchzuführen. Es ist eine plastisch verformbare fünfte Folie bereitzustellen, welche porös ist und eine Vielzahl an Poren aufweist. Die Poren sind bevorzugt als Mikroporen ausgebildet und statistisch verteilt, besonders bevorzugt statistisch gleich verteilt auf der fünften Folie angeordnet. Weiterhin ist eine dritte Opferfolie bereitzustellen. Die nachfolgend angeführten Schritte sind nach dem Entfernen der zweiten Opferfolie, bevorzugt aber vor dem Ätzen durchzuführen. Die dritte Opferfolie und die fünfte Folie sind auf den aus der verformten ersten Folie, der verformten zweiten Folie und der verformten vierten Folie gebildeten Folienverbund zu stapeln. Dabei befindet sich die fünfte Folie zwischen der dritten Opferfolie und dem Folienverbund. Die fünfte Folie schließt dabei die Kavitäten der vierten Folie ab. Im nächsten Schritt ist die dritte Opferfolie mit einem Druck, insbesondere mit einem Pressdruck zu beaufschlagen, um die fünfte Folie in den in der Form befindlichen Folienverbund zu pressen. Dadurch werden in der dritten Opferfolie und in der fünften Folie jeweils verformte Bereiche in Form von Kavitäten innerhalb der Kavitäten des Folienverbundes ausgebildet, wobei unverformte Bereiche verbleiben. Dabei wird die fünfte Folie zumindest in deren unverformten Bereichen bevorzugt stoffschlüssig mit dem Folienverbund verbunden, sodass auch die fünfte Folie Bestandteil des Folienverbundes wird. Anschließend ist die dritte Opferfolie zu entfernen.

Die Kavitäten in der verformten fünften Folie weisen bevorzugt eine geringere Tiefe als die Kavitäten in der verformten vierten Folie auf. Bevorzugt beträgt die durchschnittliche Tiefe der Kavitäten der verformten fünften Folie zwischen 20 % und 80 % der durchschnittlichen Tiefe der Kavitäten in der verformten vierten Folie. Die Poren in der fünften Folie weisen einen durchschnittlichen Durchmesser auf, der bevorzugt mehr als doppelt so groß wie der durchschnittliche Durchmesser der Poren in der vierten Folie ist. Weiterhin weist die fünfte Folie bevorzugt auch diejenigen Merkmale auf, welche für die erste Folie als bevorzugt angegeben sind. In gleicher Weise weist die dritte Opferfolie bevorzugt auch diejenigen Merkmale auf, welche für die erste Opferfolie als bevorzugt angegeben sind.

Die für die vierte Folie und die fünfte Folie sowie für die zweite Opferfolie und die dritte Opferfolie angegebenen Schritte können auch für weitere Folien und Opferfolien durchgeführt werden.

Bei bevorzugten Ausführungsformen des erfindungsgemäßen Verfahrens ist die zweite Folie eingefärbt, wofür sie bevorzugt aus einem eingefärbten Polymer besteht. Hierdurch ist die zweite Folie im ausgebildeten Formkörper leichter identifizierbar, was die Anwendung des Formkörpers für die Kultivierung von biologischen Zellen erleichtert. In gleicher Weise ist auch die dritte Folie bevorzugt eingefärbt.

Zur leichteren Identifizierung innerhalb des ausgebildeten Formkörpers ist in die zweite Folie bevorzugt ein Fluorophor eingelagert. Ebenso ist auch in die ggf. verwendete dritte Folie bevorzugt ein Fluorophor eingelagert.

Da der erfindungsgemäß herzustellende Formkörper für die Kultivierung von biologischen Zellen vorgesehen ist, werden bei besonderen Ausführungsformen des erfindungsgemäßen Verfahrens bereits bei der Herstellung des Formkörpers Stoffe eingebracht, welche im Zusammenhang mit der späteren Verwendung zur Kultivierung biologischer Zellen stehen. Insbesondere wird bevorzugt die zweite Folie mit einem Wirkstoff zur Beeinflussung biologischer Prozesse beschichtet, bevor die zweite Folie mit der ersten Folie zu dem Folienstapel gestapelt wird. Der Wirkstoff kommt bei der späteren Verwendung des hergestellten Formkörpers zum Wirken, insbesondere dadurch, dass der Wirkstoff während der Verwendung des Formkörpers an das biologische Material innerhalb der Kavitäten abgegeben wird. Weiterhin kann auch die dritte Folie mit einem Wirkstoff zur Beeinflussung biologischer Prozesse beschichtet werden, bevor diese mit der ersten Folie und der zweiten Folie zu dem Folienstapel gestapelt wird.

Der Wirkstoff befindet sich bevorzugt auf derjenigen Seite der zweiten Folie, welche beim Stapeln an der ersten Folie anliegt. In gleicher Weise befindet sich der Wirkstoff bevorzugt auf derjenigen Seite der ggf. verwendeten dritten Folie, welche beim Stapeln an der ersten Folie anliegt.

Die zweite Folie ist bevorzugt hydrophob ausgebildet. Dies führt dazu, dass bei der späteren Verwendung des herzustellenden Formkörpers zur Kultivierung von Zellen vorhandenes Wasser und die das Wasser umfassenden biologischen Zellen insbesondere durch die verbliebenen unverformten Bereiche der zweiten Folie in die Kavitäten hineingedrängt werden, wo die Kultivierung der Zellen gewünscht ist. Auch die ggf. verwendete dritte Folie ist bevorzugt hydrophob ausgebildet.

Bei besonderen Ausführungsformen des erfindungsgemäßen Verfahrens ist die zweite Folie mit einer Schicht aus einem Thermoplast beschichtet, wobei die Schicht auf derjenigen Seite der zweiten Folie angeordnet ist, welche beim Stapeln an der ersten Folie anliegt. Beim Ätzen wird bevorzugt auch die Schicht aus dem Thermoplast in den aufzulösenden Abschnitten der zweiten Folie ebenfalls chemisch aufgelöst und vernichtet, um die Poren in den freizulegenden Abschnitten der ersten Folie freizulegen. Dabei wird die Schicht aus dem Thermoplast bevorzugt zumindest auch teilweise in denjenigen Abschnitten der zweiten Folie chemisch aufgelöst und vernichtet, in denen die zweite Folie erhalten bleibt. Es kommt somit zu Hohlräumen zwischen der zweiten Folie und der ersten Folie, die sich zwischen den unverformten Bereichen der ersten Folie und den unverformten Bereichen der zweiten Folie erstrecken, aber auch zu Hohlräumen, die sich zwischen den verbliebenen verformten Bereichen der zweiten Folie und den verformten Bereichen der ersten Folie erstrecken. Die Hohlräume dienen im herzustellenden Formkörper insbesondere einem Stofftransport während der bestimmungsgemäßen Verwendung, welcher eine andere Richtung als der Stofftransport durch die Poren aufweist.

Bei denjenigen Ausführungsformen des erfindungsgemäßen Verfahrens, welche die Verwendung der dritten Folie vorsehen, weist auch die dritte Folie bevorzugt eine Schicht aus einem Thermoplast auf, wobei die Schicht auf derjenigen Seite der dritten Folie angeordnet ist, welche beim Stapeln an der ersten Folie anliegt. Beim Ätzen wird die Schicht aus dem Thermoplast in den chemisch aufzulösenden Abschnitten der dritten Folie ebenfalls chemisch aufgelöst und vernichtet, sodass die dort befindlichen Poren der ersten Folie freigelegt werden. Wie auch die Schicht aus dem Thermoplast auf der zweiten Folie wird auch die Schicht aus dem Thermoplast auf der dritten Folie beim Ätzen bevorzugt zumindest teilweise in Abschnitten der dritten Folie chemisch aufgelöst und vernichtet, in denen die dritte Folie erhalten bleibt. Hierdurch werden Hohlräume zwischen der ersten Folie und der dritten Folie gebildet.

Das erfindungsgemäße Verfahren wird bevorzugt in einem Rolle-zu-Rolle-Betrieb durchgeführt.

Weitere Vorteile, Einzelheiten und Weiterbildungen der Erfindung ergeben sich aus der nachfolgenden Beschreibung bevorzugter Ausführungsformen, unter Bezugnahme auf die Zeichnung. Es zeigen:
- Fig. 1:: die Abfolge einer ersten bevorzugten Ausführungsform des erfindungsgemäßen Verfahrens;
- Fig. 2:: die Abfolge einer zweiten bevorzugten Ausführungsform des erfindungsgemäßen Verfahrens mit einer alternativen Reihenfolge beim Stapeln von Folien;
- Fig. 3:: die Abfolge einer dritten bevorzugten Ausführungsform des erfindungsgemäßen Verfahrens unter Verwendung einer weiteren Folie; und
- Fig. 4:: eine besondere Ausführungsform des erfindungsgemäßen Verfahrens, bei welcher abgesetzte Kavitäten gebildet werden.

Fig. 1 zeigt mehrere Schritte einer ersten bevorzugten Ausführungsform des erfindungsgemäßen Verfahrens. Abb. a) der Fig. 1 zeigt einen Schritt des erfindungsgemäßen Verfahrens, bei welchem drei Folien bereitgestellt werden. Dabei handelt es sich um eine erste Folie 01, welche aus Polycarbonat besteht und eine Dicke von 50 µm aufweist. Die erste Folie 01 ist porös und weist eine Vielzahl an Poren auf, deren Durchmesser durchschnittlich 1,3 µm beträgt. Eine zweite Folie 02 besteht aus einem modifizierten Polycarbonat und weist eine Dicke von nur 5 µm auf. Die zweite Folie 02 ist unbehandelt, sodass sie keine Poren, Öffnungen oder dergleichen aufweist. Eine erste Opferfolie 03 besteht aus FEP und weist eine Dicke von 50 µm auf.

Abb. b) der Fig. 1 zeigt einen zweiten Schritt, bei welchem die drei Folien 01, 02, 03 übereinander gestapelt werden. Dabei ist die zweite Folie 02 über der ersten Folie 01 angeordnet. Die erste Opferfolie 03 liegt über der ersten Folie 01 und der zweiten Folie 02. Der aus den drei Folien 01, 02, 03 gebildete Folienstapel wird auf eine Form 04 aufgebracht, welche Ausnehmungen 06 in Form von Kavitäten aufweist. Der aus den drei Folien 01, 02, 03 gebildete Folienstapel wird in die Form 04 gepresst, indem die erste Opferfolie 03 mit einem Gasdruck beaufschlagt wird.

Abb. c) der Fig. 1 zeigt die Folien 01, 02, 03, nachdem diese in die Form 04 eingeformt wurden. Die erste Folie 01 weist nun verformte Bereiche 07 auf, die in den Ausnehmungen 06 der Form 04 ausgeformt wurden. Folglich bilden die verformten Bereiche 07 der ersten Folie 01 ebenfalls Kavitäten aus. Zwischen den verformten Bereichen 07 weist die erste Folie 01 weiterhin unverformte Bereiche 08 auf. Da die zweite Folie 02 gemeinsam mit der ersten Folie 01 verformt wurde, weist auch die zweite Folie 02 verformte Bereiche 09 und unverformte Bereiche 11 auf. Durch den ausgeübten Pressdruck wurden die erste Folie 01 und die zweite Folie 02 weitgehend stoffschlüssig miteinander verbunden, sodass sie einen Folienverbund 01, 02 ausbilden. Hierdurch sind die Poren in der ersten Folie 01 einseitig verschlossen.

Abb. d) der Fig. 1 zeigt den aus den beiden Folien 01, 02 gebildeten Folienverbund, nachdem dieser aus der Form 04 entnommen wurde und die erste Opferfolie 03 entfernt wurde. Infolge des Verformens weist die erste Folie 01 nicht mehr eine konstante Dicke auf. Aus dem gleichen Grund weist auch die zweite Folie 02 keine konstante Dicke mehr auf. Vielmehr ist die erste Folie 01 in ihren verformten Bereichen 07 verdünnt. Ebenso ist die zweite Folie 02 in ihren verformten Bereichen 09 verdünnt.

Der aus der ersten Folie 01 und der zweiten Folie 02 gebildete Folienverbund wird nun in einem Ätzbad (nicht dargestellt) geätzt. Das Ätzbad besteht aus einer 40 %-igen Natronlauge, welche eine Temperatur von 70°C besitzt. Die Eigenschaften des Ätzbades sind so bemessen, dass Abschnitte in den verformten Bereichen 09 der zweiten Folie 02 vollständig chemisch aufgelöst und dadurch vernichtet werden, während die übrigen Bereiche der zweiten Folie 02 und die gesamte erste Folie 01 zwar etwas verdünnt wird, aber erhalten bleiben.

Abb. e) der Fig. 1 zeigt den aus den beiden Folien 01 und 02 gebildeten Folienverbund nach dem Ätzen. Die verformten Bereiche 09 der zweiten Folie 02 sind nur noch ansatzweise vorhanden. Dadurch sind Abschnitte 12 in den die Kavitäten bildenden verformten Bereiche 07 der ersten Folie 01 nicht mehr durch die zweite Folie 02 bedeckt, sodass die dort befindlichen Poren der ersten Folie 01 wieder freigegeben und somit durchlässig sind. Die Poren in den Abschnitten 12 der ersten Folie 01 wurden durch das Ätzen vergrößert und weisen nunmehr einen durchschnittlichen Durchmesser von etwa 3,5 µm auf.

Der aus der ersten Folie 01 und den verbliebenen Bestandteilen der zweiten Folie 02 gebildete Folienverbund stellt den erfindungsgemäß herzustellenden Formkörper dar.

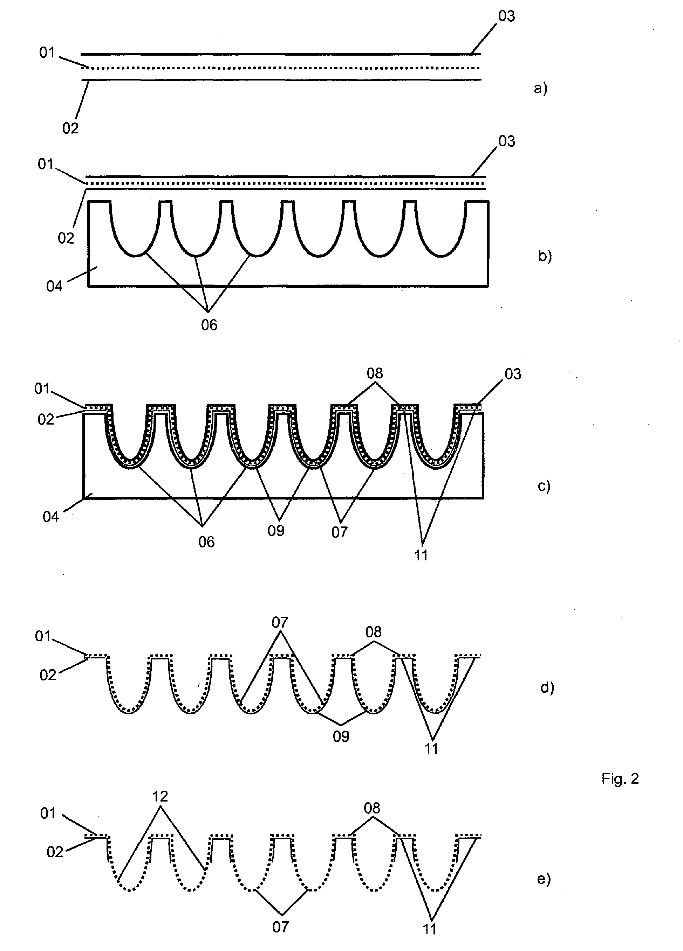

Fig. 2 zeigt mehrere Schritte einer zweiten bevorzugten Ausführungsform des erfindungsgemäßen Verfahrens. Die in den Abbildungen a), b), c), d) und e) der Fig. 2 gezeigten Schritte gleichen grundsätzlich den in den Abbildungen a), b), c), d) und e) der Fig. 1 gezeigten Schritten. Der einzige Unterschied zwischen der in Fig. 1 gezeigten Ausführungsform und der in Fig. 2 gezeigten Ausführungsform des erfindungsgemäßen Verfahrens besteht in der Reihenfolge beim Stapeln der ersten Folie 01 und der zweiten Folie 02. Bei der in Fig. 2 gezeigten Ausführungsform wird die erste Folie 01 zwischen der zweiten Folie 02 und der ersten Opferfolie 03 angeordnet. Dies führt im Ergebnis dazu, dass bei dem ausgebildeten Formkörper (gezeigt in Abb. e) der Fig. 2) die verbleibenden Anteile der zweiten Folie 02 außerhalb der durch die verformten Bereiche 07 der ersten Folie 01 gebildeten Kavitäten angeordnet ist, wohingegen bei dem Formkörper im Ergebnis der in Fig. 1 gezeigten Ausführungsform des erfindungsgemäßen Verfahrens die verbleibenden Anteile der zweiten Folie 02 (gezeigt in Abb. e) der Fig. 1) teilweise innerhalb der durch die verformten Bereiche 07 der ersten Folie 01 gebildeten Kavitäten angeordnet sind.

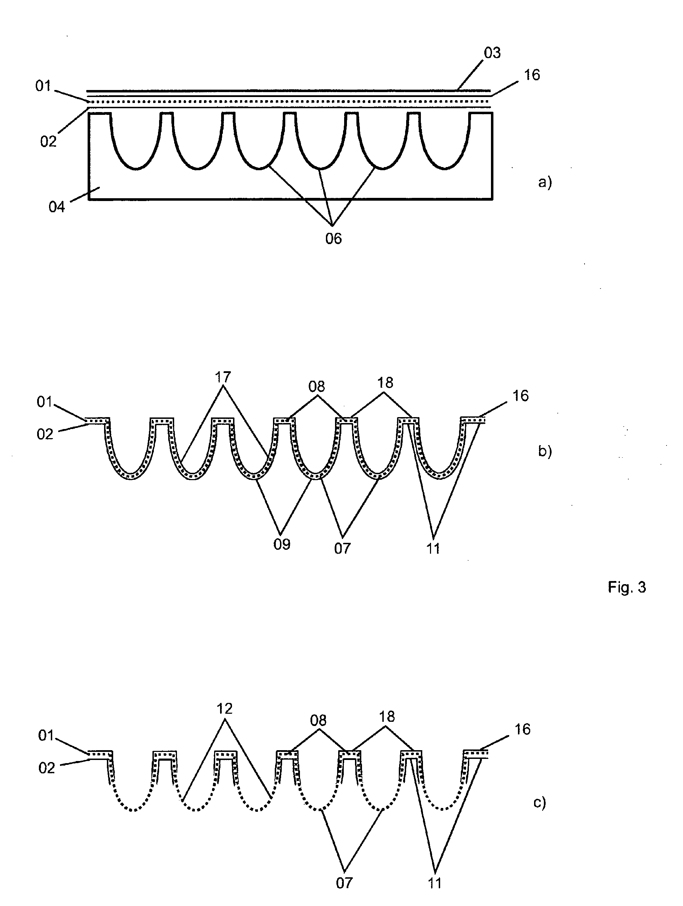

Fig. 3 zeigt mehrere Schritte einer dritten bevorzugten Ausführungsform des erfindungsgemäßen Verfahrens. Bei dieser Ausführungsform wird ebenso wie bei den in Fig. 1 und 2 gezeigten Ausführungsformen die erste Folie 01 mit der zweiten Folie 02 verbunden, um zunächst sämtliche Poren in der ersten Folie 01 zu verschließen. In Erweiterung zu den in den Fig. 1 und 2 gezeigten Ausführungsformen wird bei der in Fig. 3 gezeigten Ausführungsform eine dritte Folie 16 verwendet, um die erste Folie 01 beidseitig zu bedecken. Die dritte Folie 16 gleicht der zweiten Folie 02.

In dem in Abb. a) der Fig. 3 gezeigten Schritt werden die erste Folie 01, die zweite Folie 02, die dritte Folie 16 und die erste Opferfolie 03 übereinander geordnet, wobei die erste Folie 01 zwischen der zweiten Folie 02 und der dritten Folie 16 angeordnet wird. Die erste Opferfolie 03 wird über der ersten Folie 01, der zweiten Folie 02 und der dritten Folie 16 angeordnet. Die erste Opferfolie 03 wird ebenso wie bei den in den Fig. 1 und 2 gezeigten Ausführungsformen mit einem Gasdruck beaufschlagt, um den aus der ersten Folie 01, der zweiten Folie 02 und der dritten Folie 16 gebildeten Folienstapel in die Form 04 einzuformen.

Im Ergebnis des Formvorganges liegt der in Abb. b) der Fig. 3 gezeigte Folienverbund vor, welcher aus der verformten ersten Folie 01, der verformten zweiten Folie 02 und der verformten dritten Folie 16 gebildet ist. Die verformte dritte Folie 16 weist ebenso wie die erste Folie 01 und die zweite Folie 02 verformte Bereiche 17 und unverformte Bereiche 18 auf. Die verformte dritte Folie 16 ist weitgehend stoffschlüssig mit der ersten Folie 01 verbunden. Es erfolgt ebenso wie bei den in Fig. 1 und 2 gezeigten Ausführungsformen ein Ätzen des Folienverbundes.

Abb. c) der Fig. 3 zeigt den im Ergebnis des Ätzens vorliegenden Formkörper. Dieser Formkörper gleicht hinsichtlich der Ausbildung der ersten Folie 01 und den verbleibenden Anteilen der zweiten Folie 02 den in Abb. e) der Fig. 2 gezeigten Formkörper. Ebenso wie die Abschnitte der verformten Bereiche 09 der zweiten Folie 02 wurden auch Abschnitte in den verformten Bereichen 17 der dritten Folie 16 durch den Ätzvorgang chemisch aufgelöst und somit vernichtet. Dies gleicht insoweit dem chemischen Auflösen der Abschnitte der zweiten Folie 02 der in Fig. 1 gezeigten Ausführungsform. Die unverformten Bereiche 08 der ersten Folie 01 sowie Teile der verformten Bereiche 07 der ersten Folie 01 sind durch die verbleibenden Anteile der zweiten Folie 02 und durch die verbleibenden Anteile der dritten Folie 16 bedeckt, sodass die dort befindlichen Poren beidseitig verschlossen sind, wohingegen die Poren in den Abschnitten 12 in den verformten Bereichen 07 der ersten Folie 01 geöffnet sind.

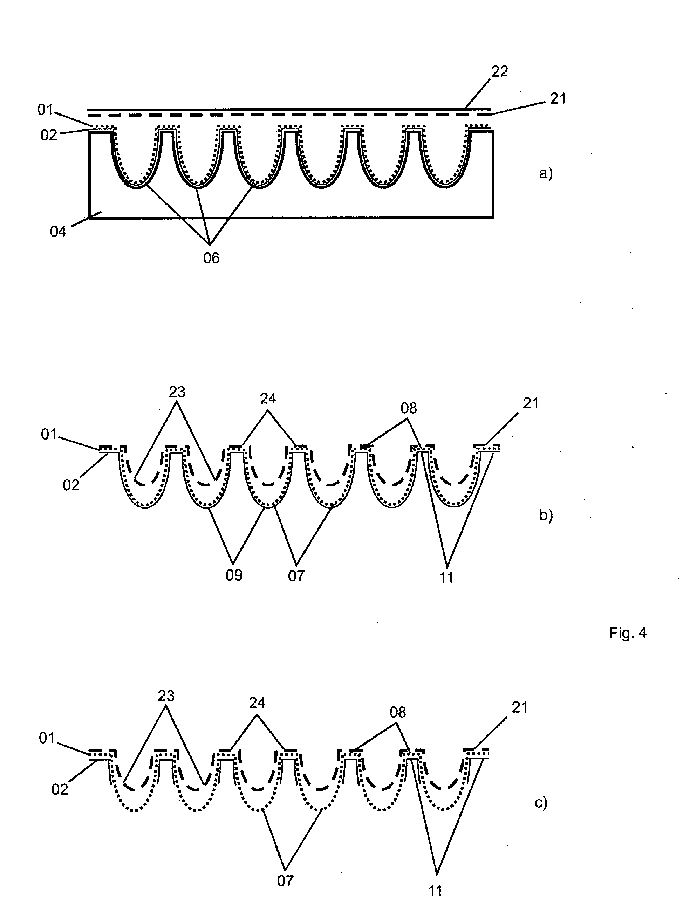

Fig. 4 zeigt eine besondere Ausführungsform des erfindungsgemäßen Verfahrens. Diese Ausführungsform weist zunächst diejenigen Schritte auf, wie sie in den Abbildungen a), b), c) und d) der Fig. 2 gezeigt sind. Im Gegensatz zu der in Fig. 2 gezeigten Ausführungsform wird vor dem Ätzen eine vierte Folie 21 in den aus der verformten ersten Folie 01 und der verformten zweiten Folie 02 gebildeten Folienverbund eingeformt.

Abb. a) der Fig. 4 zeigt einen Schritt, bei welchem die vierte Folie 21 über dem aus der verformten ersten Folie 01 und der verformten zweiten Folie 02 gebildeten Folienverbund angeordnet wird. Die vierte Folie 21 besteht wie die erste Folie 01 aus Polycarbonat und weist eine Dicke von 50 µm auf. Die vierte Folie 21 ist ebenfalls porös, wobei die Poren in der vierten Folie 21 etwa doppelt so groß wie die Poren in der ersten Folie 01 sind. Über der vierten Folie 21 wird eine zweite Opferfolie 22 angeordnet. Die zweite Opferfolie 22 wird mit einem Gasdruck beaufschlagt, um die vierte Folie 21 in die Kavitäten in die verformten Bereiche 07 der ersten Folie 01 einzuformen. Dabei wird die vierte Folie 21 nicht vollständig in die verformten Bereiche 07 der ersten Folie 01 eingeformt.

Abb. b) der Fig. 4 zeigt den aus der verformten ersten Folie 01 und der verformten zweiten Folie 02 gebildeten Folienverbund, in welchen die vierte Folie 21 teilweise eingeformt ist. Die vierte Folie 21 weist nun ebenso wie die erste Folie 01 und die zweite Folie 02 verformte Bereiche 23 und unverformte Bereiche 24 auf. Die verformten Bereiche 23 bilden Kavitäten aus, welche eine Tiefe besitzen, die nur etwa 50 % der Tiefe der Kavitäten in den verformten Bereichen 07 der ersten Folie 01 beträgt. Beim Zusammenpressen der vierten Folie 21 mit dem aus der verformten ersten Folie 01 und der verformten zweiten Folie 02 gebildeten Folienverbund kam es auch dazu, dass die vierte Folie 21 weitgehend stoffschlüssig mit der ersten Folie 01 verbunden wurde, insbesondere in den unverformten Bereichen 24. Dies führte dazu, dass nunmehr auch die vierte Folie 21 zu einem Bestandteil des Folienverbundes wurde, welchem zunächst nur die verformte erste Folie 01 und die verformte zweite Folie 02 angehörten. Anschließend erfolgt ein Ätzen des Folienverbundes in gleicher Weise wie bei der in Fig. 2 gezeigten Ausführungsform.

Abb. c) der Fig. 4 zeigt den im Ergebnis des Ätzvorganges vorliegenden Formkörper. Die zweite Folie 02 wurde in Abschnitten ihrer verformten Bereiche 09 vollständig aufgelöst, sodass die darunter befindlichen Abschnitte 12 der ersten Folie 01 freigelegt sind. Insoweit gleicht dieser Formkörper dem in Abb. e) der Fig. 2 gezeigten Formkörper. Zusätzlich bildet die verformte vierte Folie 21 einen Teil des Formkörpers.

### Bezugszeichenliste

- 01 -: erste Folie
- 02 -: zweite Folie
- 03 -: erste Opferfolie
- 04 -: Form
- 05 -: -
- 06 -: Ausnehmungen
- 07 -: verformte Bereiche der ersten Folie
- 08 -: unverformte Bereiche der ersten Folie
- 09 -: verformte Bereiche der zweiten Folie
- 10 -: -
- 11 -: unverformte Bereiche der zweiten Folie
- 12 -: freigelegte Abschnitte der ersten Folie
- 13 -: -
- 14 -: -
- 15 -: -
- 16 -: dritte Folie
- 17 -: verformte Bereiche der dritten Folie
- 18 -: unverformte Bereiche der dritten Folie
- 19 -: -
- 20 -: -
- 21 -: vierte Folie
- 22 -: zweite Opferfolie
- 23 -: verformte Bereiche der vierten Folie
- 24 -: unverformte Bereiche der vierten Folie

## Patentansprüche

1. Verfahren zur Herstellung eines mikrostrukturierten Formkörpers, folgende Schritte umfassend:
- Bereitstellen einer plastisch verformbaren ersten Folie (01), die eine Vielzahl an Poren aufweist;
- Bereitstellen einer verformbaren zweiten Folie (02);
- Bereitstellen einer verformbaren ersten Opferfolie (03);
- Stapeln der ersten Folie (01), der zweiten Folie (02) und der ersten Opferfolie (03) zu einem Folienstapel (01, 02, 03), wobei die erste Folie (01) und die zweite Folie (02) gemeinsam der ersten Opferfolie (03) gegenüberliegen;
- Beaufschlagen der ersten Opferfolie (03) mit einem Druck, um den Folienstapel (01, 02, 03) in eine Form (04) zu pressen, wodurch in der ersten Opferfolie (03), in der ersten Folie (01) und in der zweiten Folie (02) jeweils verformte Bereiche (07, 09) in Form von Kavitäten ausgebildet werden und unverformte Bereiche (08, 11) verbleiben, und wodurch die erste Folie (01) und die zweite Folie (02) miteinander verbunden werden und einen Folienverbund (01, 02) ausbilden;
- Entfernen der ersten Opferfolie (03) vom Folienverbund (01, 02); und
- Ätzen von zumindest Teilen der verformten Bereiche (09) der zweiten Folie (02), um Abschnitte in den verformten Bereichen (09) der zweiten Folie (02) chemisch aufzulösen, wodurch Abschnitte (12) in den verformten Bereichen (07) der ersten Folie (01) freigelegt werden;
wobei die zweite Folie (02) beim Pressen in die Form (04) in den verformten Bereichen (09) verdünnt wird, wodurch das chemische Auflösen auf die Abschnitte in den verformten Bereichen (09) der zweiten Folie (02) begrenzt ist.

2. Verfahren nach Anspruch 1, **dadurch gekennzeichnet, dass** die erste Folie (01) und die zweite Folie (02) stoffschlüssig miteinander verbunden werden.

3. Verfahren nach Anspruch 1 oder 2, **dadurch gekennzeichnet, dass** die Poren in der ersten Folie (01) beim Bereitstellen der ersten Folie (01) einen Durchmesser zwischen 500 nm und 2 µm aufweisen.

4. Verfahren nach einem der Ansprüche 1 bis 3, **dadurch gekennzeichnet, dass** die erste Folie (01) mindestens 10⁵ Poren je cm² aufweist.

5. Verfahren nach einem der Ansprüche 1 bis 4, **dadurch gekennzeichnet, dass** die erste Folie (01) beim Bereitstellen eine Dicke zwischen 20 µm und 80 µm besitzt.

6. Verfahren nach einem der Ansprüche 1 bis 5, **dadurch gekennzeichnet, dass** die Form (04) Ausnehmungen (06) zur Ausformung der Kavitäten aufweist, wobei die Ausformungen (04) einen Durchmesser zwischen 50 µm und 500 µm besitzen.

7. Verfahren nach einem der Ansprüche 1 bis 6, **dadurch gekennzeichnet, dass** die zweite Folie (02) in den verformten Bereichen (09) eine Dicke aufweist, die weniger als 50 % ihrer Dicke vor dem Verformen beträgt.

8. Verfahren nach einem der Ansprüche 1 bis 7, **dadurch gekennzeichnet, dass** weiterhin eine dritte Folie (16) bereitgestellt wird, wobei:
- die dritte Folie (16) gemeinsam mit der ersten Folie (01), der zweiten Folie (02) und der ersten Opferfolie (03) zu dem Folienstapel (01, 02, 03, 16) gestapelt wird, wobei die erste Folie (01) zwischen der zweite Folie (02) und der dritten Folie (16) angeordnet wird, und wobei die erste Folie (01), die zweite Folie (02) und die dritte Folie (16) gemeinsam der ersten Opferfolie (03) gegenüberliegen;
- beim Pressen des Folienstapels (01, 02, 03, 16) in die Form (04) auch in der dritten Folie (16) verformte Bereiche (17) in Form von Kavitäten ausgebildet werden und unverformte Bereiche (18) verbleiben, und wobei auch die erste Folie (01) und die dritte Folie (16) miteinander verbunden werden und gemeinsam mit der zweiten Folie (02) den Folienverbund (01, 02, 16) ausbilden; und wobei
- auch zumindest Teile der verformten Bereiche (17) der dritten Folie (16) geätzt werden, um Abschnitte in den verformten Bereichen (17) der dritten Folie (16) chemisch aufzulösen, wodurch Abschnitte (12) in den verformten Bereichen (07) der ersten Folie (01) freigelegt werden.

9. Verfahren nach einem der Ansprüche 1 bis 8, **dadurch gekennzeichnet, dass** es weiterhin folgende Schritte umfasst:
- Bereitstellen einer plastisch verformbaren vierten Folie (21), die eine Vielzahl an Poren aufweist; und
- Bereitstellen einer zweiten Opferfolie (22);
wobei nachfolgend angeführte Schritte nach dem Entfernen der ersten Opferfolie (03) erfolgen:
- Stapeln der zweiten Opferfolie (22) und der vierten Folie (21) auf den Folienverbund (01, 02);
- Beaufschlagen der zweiten Opferfolie (22) mit einem Pressdruck, um die vierte Folie (21) in den in der Form (04) befindlichen Folienverbund (01, 02) zu pressen, wodurch in der zweiten Opferfolie (22) und in der vierten Folie (21) jeweils verformte Bereiche (23) in Form von Kavitäten innerhalb der Kavitäten des Folienverbundes (01, 02) ausgebildet werden und unverformte Bereiche (24) verbleiben, und wodurch die vierte Folie (21) in deren unverformten Bereichen (24) mit dem Folienverbund (01, 02) verbunden wird und Bestandteil des Folienverbundes (01, 02, 24) wird; und
- Entfernen der zweiten Opferfolie (22).

## Claims

1. Method for the production of a microstructured molded object, comprising following steps:
- preparing a plastically deformable first film (01), which has a plurality of pores;
- preparing a deformable second film (02);
- preparing a deformable first sacrificial film (03);
- placing the first film (01), the second film (02) and the first sacrificial film (03) in a stack of films (01, 02, 03), where the first film (01) and the second film (02) together lie opposite the first sacrificial film (03) ;
- subjecting the first sacrificial film (03) to a pressure to press the stack of films (01, 02, 03) into a mold (04), whereby deformed regions (07, 09) in the form of cavities are produced in the first sacrificial film (03), in the first film (01) and in the second film (02), and undeformed regions (08, 11) remain, and whereby the first film (01) and the second film (02) are joined to each other and form a composite film (01, 02);
- removing the first sacrificial film (03) from the composite film (01, 02); and
- etching at least portions of the deformed regions (09) of the second film (02) so as to chemically dissolve sections of the deformed regions (09) of the second film (02), whereby sections (12) in the deformed regions (07) of the first film (01) are opened up;
wherein the second film (02) is thinned out during the pressing into the mold (04) in the deformed regions (09) so that the chemical dissolution is confined to the sections in the deformed regions (09) of the second film (02).

2. Method according to claim 1, **characterized in that** the first film (01) and the second film (02) are materially bonded together.

3. Method according to claim 1 or 2, **characterized in that** the pores in the first film (01) during the preparation have a diameter between 500 nm and 2 µm.

4. Method according to one of claims 1 to 3, **characterized in that** the first film (01) has at least 10⁵ pores per cm².

5. Method according to one of claims 1 to 4, **characterized in that** the first film (01) during preparation has a thickness between 20 µm and 80 µm.

6. Method according to one of claims 1 to 5, **characterized in that** the mold (04) has configurations (06) for the formation of cavities, and that the moldings (04) have a diameter between 50 µm and 500 µm.

7. Method according to one of claims 1 to 6, **characterized in that** the second film (02) has a thickness in the deformed regions (09) that is less than 50 % of its thickness prior to deformation.

8. Method according to one of claims 1 to 7, **characterized in that** a third film (16) is furthermore prepared, wherein:
- the third film (16) is stacked together with the first film (01), the second film (02) and the first sacrificial film (03) in the film stack (01, 02, 03, 16), wherein the first film (01) is arranged between the second film (02) and the third film (16) and wherein the first film (01), the second film (02) and the third film (16) together lie opposite the first sacrificial film (03) ;
- during the pressing of the film stack (01, 02, 03, 16) into the mold (04), deformed regions (17) in the form of cavities are also formed in the third film (16) and undeformed regions (18) remain, and wherein the first film (01) and the third film (16) are also joined together and, together with the second film (02), form the composite film (01, 02, 16); and wherein
- at least portions of the deformed regions (17) of the third film (16) are also etched so that sections in the deformed regions (17) of the third film (16) are chemically dissolved, thereby freeing up sections (12) in the deformed regions (07) of the first film (01).

9. Method according to one of claims 1 to 8, **characterized in** further comprising following steps:
- preparing a plastically deformable fourth film (21), having a plurality of pores; and
- preparing a second sacrificial film (22);
wherein after the removal of the first sacrificial film (03) following steps are carried out:
- stacking of the second sacrificial film (22) and the fourth film (21) on the composite film (01, 02);
- subjecting the second sacrificial film (22) to a pressing force, to press the fourth film (21) into the composite film (01, 02) situated in the mold (04), whereupon deformed regions (23) are formed in the second sacrificial film (22) and in the fourth film (21) in the form of cavities within the cavities of the composite film (01, 02) and undeformed regions (24) remain, and whereupon the fourth film (21) is connected to the composite film (01, 02) in its undeformed regions (24) and becomes part of the composite film (01, 02, 24); and
- removing the second sacrificial film (22).

## Revendications

1. Procédé de fabrication d'un corps de moule microstructuré, comprenant les étapes suivantes :
- préparation d'un premier film plastiquement déformable (01) qui présente une pluralité de pores ;
- préparation d'un deuxième film déformable (02) ;
- préparation d'un premier film sacrifié déformable (03) ;
- empilement du premier film (01), du deuxième film (02) et du premier film sacrifié (03) en une pile de films (01, 02, 03), sachant que le premier film (01) et le deuxième film (02) font face en commun au premier film sacrifié (03) ;
- application d'une pression sur le premier film sacrifié (03) pour comprimer la pile de films (01, 02, 03) dans un moule (04), ce qui produit des zones déformées respectives (07, 09) sous forme de cavités dans le premier film sacrifié (03), dans le premier film (01) et dans le deuxième film (02) et zones non déformées (08, 11) restent, et ce qui fait que le premier film (01) et le deuxième film (02) sont reliés entre eux et forment un composite de films (01, 02) ;
- enlèvement du premier film sacrifié (03) du composite de films (01, 02) ; et
- corrodage d'au moins des parties des zones déformées (09) du deuxième film (02) pour dissoudre chimiquement des tronçons dans les zones déformées (09) du deuxième film (02), ce qui dégage des tronçons (12) dans les zones déformées (07) du premier film (01) ;
sachant que le deuxième film (02) est aminci dans les zones déformées (09) lorsqu'il est comprimé dans le moule (04), ce qui limite la dissolution chimique aux tronçons dans les zones déformées (09) du deuxième film (02).

2. Procédé selon la revendication 1, **caractérisé en ce que** le premier film (01) et le deuxième film (02) sont reliés entre eux par adhérence de matière.

3. Procédé selon la revendication 1 ou 2, **caractérisé en ce que** les pores dans le premier film (01) lors de la préparation du premier film (01) présentent un diamètre entre 500 nm et 2 µm.

4. Procédé selon l'une des revendications 1 à 3, **caractérisé en ce que** le premier film (01) présente au moins 10⁵ pores par cm².

5. Procédé selon l'une des revendications 1 à 4, **caractérisé en ce que** le premier film (01) a une épaisseur entre 20 µm et 80 µm lors de la préparation.

6. Procédé selon l'une des revendications 1 à 5, **caractérisé en ce que** le moule (04) présente des évidements (06) pour former des cavités, sachant que les formations (04) présentent un diamètre entre 50 µm et 500 µm.

7. Procédé selon l'une des revendications 1 à 6, **caractérisé en ce que** le deuxième film (02) présente une épaisseur dans les zones déformées (09) qui fait moins de 50 % de son épaisseur avant la déformation.

8. Procédé selon l'une des revendications 1 à 7, **caractérisé en ce qu'**un troisième film (16) est en outre préparé, sachant que
- le troisième film (16) est empilé conjointement avec le premier film (01), le deuxième film (02) et le premier film sacrifié (03) sur la pile de films (01, 02, 03, 16), sachant que le premier film (01) est disposé entre le deuxième film (02) et le troisième film (16), et sachant que le premier film (01), le deuxième film (02) et le troisième film (16) font face en commun au premier film sacrifié (03) ;
- lors de la compression de la pile de films (01, 02, 03, 16) dans le moule (04), des zones déformées (17) sous forme de cavités sont également formées dans le troisième film (16) et des zones non déformées (18) restent, sachant que le premier film (01) et le troisième film (16) sont également reliés entre eux et forment le composite de films (01, 02, 16) conjointement avec le deuxième film (02) ; et sachant
- qu'également au moins des parties des zones déformées (17) du troisième film (16) sont corrodées pour dissoudre chimiquement des tronçons dans les zones déformées (17) du troisième film (16), ce qui dégage des tronçons (12) dans les zones déformées (07) du premier film (01).

9. Procédé selon l'une des revendications 1 à 8, **caractérisé en ce qu'**il comprend en outre les étapes suivantes :
- préparation d'un quatrième film (21) plastiquement déformable qui présente une pluralité de pores ; et
- préparation d'un second film sacrifié (22) ;
sachant que des étapes listées ci-après ont lieu après l'enlèvement du premier film sacrifié (03) :
- empilement du second film sacrifié (22) et du quatrième film (21) sur le composite de films (01, 02) ;
- application d'une force de compression sur le second film sacrifié (22) pour comprimer le quatrième film (21) dans le composite de films (01, 02) se trouvant dans le moule (04), ce qui produit des zones déformées respectives (23) sous forme de cavités à l'intérieur des cavités du composite de films (01, 02) dans le second film sacrifié (22) et dans le quatrième film (21), et des zones non déformées (24) restent, et ce qui fait que le quatrième film (21) est relié au composite de films (01, 02) dans ses zones non déformées (24) et fait partie intégrante du composite de films (01, 02, 24) ; et
- enlèvement du second film sacrifié (22).
